# EUROPEAN PATENT SPECIFICATION

(11) **EP 2 721 447 B1**
(45) Date of publication and mention of the grant of the patent: **01.02.2017**
(21) Application number: 12758669.1
(22) Date of filing: 12.06.2012
(51) Int. Cl.: G03F 7/00, G03F 7/20

(54) **METHOD OF 2D AND 3D OPTICALLY ASSISTED FOUNTAIN PEN NANOLITHOGRAPHY AND APERTURE PEN NANOLITHOGRAPHY**
VERFAHREN ZUR 2D UND 3D OPTISCHUNTERSTÜTZE FOUNTAIN PEN ODER APERTURE PEN LITHOGRAPHIE
PROCÉDÉ DE NANOLITHOGRAPHIE EN 2D ET 3D, ASSISTÉE OPTIQUEMENT, UTILISANT UN STYLO À CARTOUCHE OU À OUVERTURE

(30) Priority: 16.06.2011 RO 201100571
(43) Date of publication of application: 23.04.2014
(73) Proprietor: Institutul National de Cercetare-Dezvoltare Pentru Microtehnologie, 077190 Bucuresti-Voluntari (RO)
(72) Inventor: MOAGÄR-POLADIAN, Gabriel, Bucuresti (RO)
(74) Representative: Fierascu, Cosmina-Catrinel
(86) International application number: PCT/RO2012/000012
(87) International publication number: WO 2012/173506

(56) References cited:
- EP-B1- 1 556 737
- US-A1- 2004 026 007
- US-B1- 7 060 977
- LING HUANG ET AL: "Matrix-Assisted Dip-Pen Nanolithography and Polymer Pen Lithography", SMALL, vol. 6, no. 10, 2 November 2009 (2009-11-02), pages 1077-1081, XP55035304, ISSN: 1613-6810, DOI: 10.1002/smll.200901198
- MOLDOVAN N ET AL: "A multi-ink linear array of nanofountain probes", JOURNAL OF MICROMECHANICS & MICROENGINEERING, INSTITUTE OF PHYSICS PUBLISHING, BRISTOL, GB, vol. 16, no. 10, 1 October 2006 (2006-10-01), pages 1935-1942, XP020104758, ISSN: 0960-1317, DOI: 10.1088/0960-1317/16/10/004

## Description

The invention refers to a method for 2D and 3D optically assisted fountain pen and aperture pen nanolithography that is used for allowing realization of nanometric scale patterns that have a better edge accuracy and possess a better resolution than normal fountain pen and aperture pen nanolithography. In the following, fountain pen nanolithography as well as aperture pen nanolithography will be designated with a single name, which is fountain pen nanolithography. In this type of nanolithography, the material that has to be deposited is in liquid form and is designated as ink. This ink passes through a microfluidic chip and is deposited onto a substrate by passing first through the tip aperture of a cantilever. The tip of the cantilever is perforated.

It is known a method of nanolithography that is based on the deposition of a liquid material onto the substrate by using the tip of a cantilever, the liquid being situated on the external part of the tip and the cantilever being not perforated. This kind of nanolithography it is called dip pen nanolithography. The liquid, once it reaches the substrate, it diffuses onto it. The diffusion depends on the properties of the liquid and of the substrate, temperature, humidity and substrate local roughness / topography. The temperature and the humidity can be controlled.

It is known a method of nanolithography called fountain pen that is based on the flow of the liquid material / ink onto the substrate through the aperture of a cantilever's tip. Once the ink reaches the substrate, it diffuses onto it. The diffusion depends on the properties of the liquid and of the substrate, temperature, humidity and substrate local roughness / topography. The temperature and the humidity can be controlled.

It is known a method of fountain pen nanolithography in which a liquid photopolymer, in its monomer form, is first deposited onto substrate. Then, after the lithography process is finished, a light with appropriate wavelength is applied to the photopolymer causing its photopolymerization.

Document US2004/026007A1 discloses a method of 2D and 3D optically assisted nanolitography consisting in depositing an ink onto a surface of a substrate by using a cantilever tip that is moving with appropriate speed horizontally and/or vertically with respect to the substrate surface, the cantilever having an inner channel connected to a reservoir that feeds with ink the aperture at its tip while a light beam is applied on the deposition region before, during or after ink deposition, the beam having the role of initiating the photopolymerization of the ink.

Document XP055035304 discloses a matrix assisted dip-pen nanolitography and polymer pen litography method that teaches how to overcome the solubility and surface interactions that inhibit uniform pattern formation, by using an ink with a particular chemical composition, wherein the curing occurs after the ink is deposited on the substrate.

The drawbacks of the dip pen nanolithography are:
- it depends strongly on the local topography / roughness of the substrate. This local topography cannot be controlled in an efficient way.
- the dependence of the ink diffusion on the local topography has as a consequence that the width of the realized patterns is difficult to be controlled in a proper manner.
- the dependence of the ink diffusion on the local topography has as a consequence that the aspect of the margins of the realized patterns has an undulated shape.
- the dependence of the ink diffusion on the local topography has as a consequence that the resolution of the patterns be not very high if the substrate roughness is greater than 10 nm.
- viscous inks may be used for reducing the ink diffusion onto the substrate, but this limits the deposition speed and does allow for a wide palette of patterns width.
- does not allow realization of 3D structures since the ink is liquid at room temperature.

The drawbacks of the fountain pen nanolithography are:
- it depends strongly on the local topography / roughness of the substrate. This local topography cannot be controlled in an efficient way.
- the dependence of the ink diffusion on the local topography has as a consequence that the width of the realized patterns is difficult to be controlled in a proper manner.
- the dependence of the ink diffusion on the local topography has as a consequence that the aspect of the margins of the realized patterns has an undulated shape.
- the dependence of the ink diffusion on the local topography has as a consequence that the resolution of the patterns be not very high if the substrate roughness is greater than 10 nm.
- viscous inks may be used for reducing the ink diffusion onto the substrate, but this limits the deposition speed and does allow for a wide palette of patterns width.
- does not allow realization of 3D structures since the ink is liquid at room temperature.

The drawbacks of the fountain pen nanolithography with photopolymer are:
- it depends strongly on the local topography / roughness of the substrate. This local topography cannot be controlled in an efficient way.
- the dependence of the ink diffusion on the local topography has as a consequence that the width of the realized patterns is difficult to be controlled in a proper manner.
- the dependence of the ink diffusion on the local topography has as a consequence that the aspect of the margins of the realized patterns has an undulated shape.
- the dependence of the ink diffusion on the local topography has as a consequence that the resolution of the patterns be not very high if the substrate roughness is greater than 10 nm.
- viscous inks may be used for reducing the ink diffusion onto the substrate, but this limits the deposition speed and does allow for a wide palette of patterns width.
- even if the ink is photopolymerized, this process occurs after the ink has diffused onto the surface. Because of that, the disadvantages mentioned above are not mitigated.

The technical problem solved by the present invention resides in that it allows a reduction of the dependence of ink diffusion on the local roughness / topography, thus allowing for the possibility to obtain patterns with improved resolution and with good edge quality. At the same time, it allows for a better deposition speed and for 3D construction.

The proposed solution, according to the invention, eliminates the drawbacks mentioned above by allowing the control of the ink diffusion process onto the substrate just at the moment when the ink exits from the aperture tip of the cantilever and reaches the substrate. This is possible due either to the use of a photopolymerizable ink that is exposed to light of appropriate wavelength since its exit from the tip aperture or, in another case, to a rapid evaporation of the solvent contained by ink as a consequence of irradiation with a light beam. More exactly, the ink diffusion coefficient is decreased in such a way that the dependence of the diffusion coefficient on the substrate roughness is significantly reduced. The initial low viscosity of the ink is small enough to allow for a fast initial flow from the tip aperture to the substrate, thus enabling an increased deposition speed. In this way, the quality of the patterns and the pattern resolution are significantly improved. The viscosity of the ink starts to increase immediately after it reaches the substrate due either to the initialization of the ink photopolymerization process or, in another case, to the fast evaporation of the solvent contained by ink because of ink illumination. In this way, the ink diffusion onto the substrate is reduced. Moreover, the proposed solution allows the realization of 3D structures at the micro- and nanoscale due to its ability to finely control the ink deposition process.

The advantages of the proposed invention are:
- the deposition of the material onto the substrate it does not depend in a significant manner on the local roughness / topography of the substrate.
- the reduced dependence on the substrate roughness allows for a better control of pattern widths.
- the reduced dependence on the substrate roughness allows for a better quality of the pattern edges.
- the reduced dependence on the substrate roughness allows for a better pattern resolution even if the substrate roughness exceeds 10 nm.
- inks with low initial viscosity are used, thus allowing an easy and fast deposition process and, at the same time, assuring the possibility to obtain a very large palette of the patterns width.

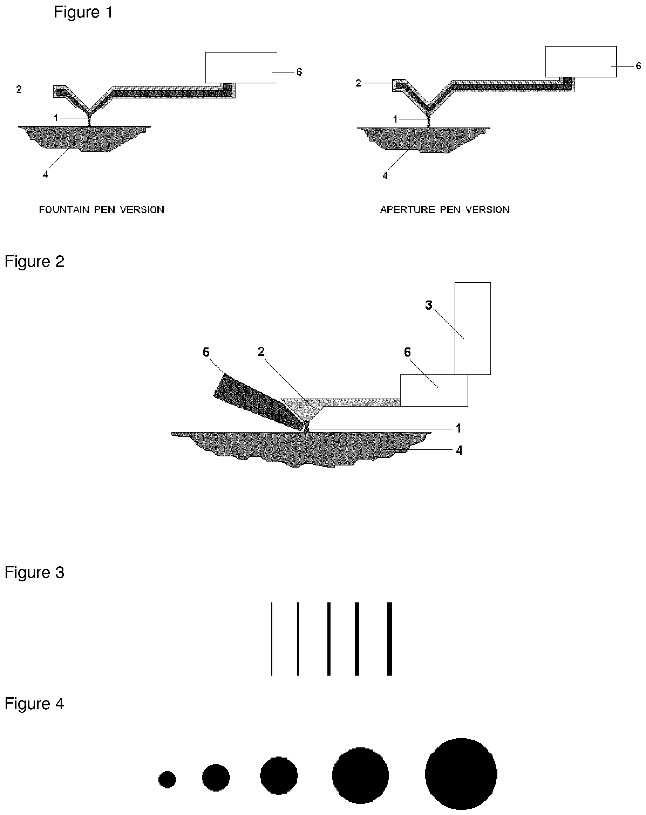

We present in the following an example of invention realization with respect to figures 1..7, which represent:
- Figure 1: schematic representation of ink depositing system, cantilever 2 is represented sectioned in order to ease understanding of the working principle
- Figure 2: schematic representation of the ensemble used for the application of the method
- Figure 3: example of a pattern used for 2D calibration using lines, view from above
- Figure 4: example of a pattern used for 2D calibration using dot patterns, view from above

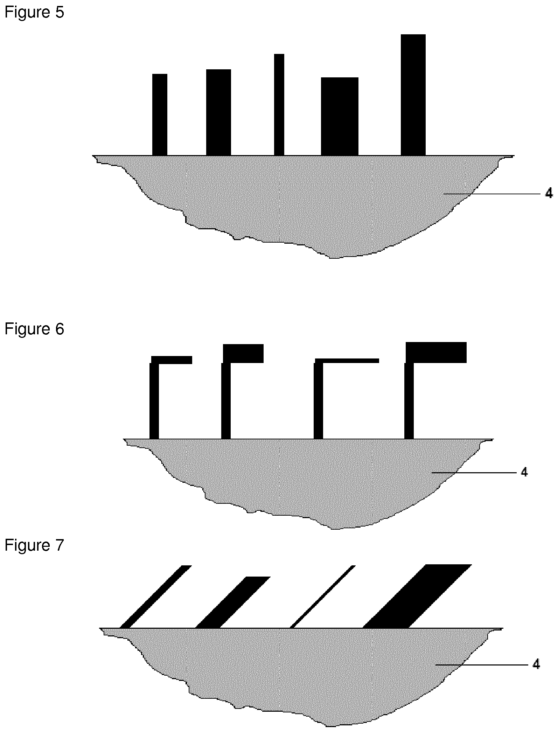

- Figure 5: example of a pattern used for 3D calibration using vertical columns, lateral view
- Figure 6: example of a pattern used for 3D calibration using vertical columns continued with a horizontal suspended line, lateral view
- Figure 7: example of a pattern used for 3D calibration using inclined columns, lateral view

In one of its embodiments for optically assisted fountain pen nanolithography, the invention uses a photopolymer that, in its monomer / unilluminated phase, has a low viscosity. This solution, called ink 1, is deposited through a cantilever 2 attached to a feeding and scanning system 3 onto the substrate 4. This deposition is made by one of the ways used in existing fountain pen nanolithography methods / techniques. Simultaneously with the deposition of ink 1 onto the substrate 4 a light beam 5 is applied and shines over the substrate 4 region that includes the contact point between ink 1 and substrate 4. The wavelength of the beam 5 is chosen in such a way so as to promote the photopolymerization of ink 1. Ink 1 is chosen in such a way so as to have short reticulation time. Moreover, the reticulation time of ink 1 depends also on the intensity of the light beam 5. Thus, the ink 1 becomes more viscous because of reticulation and spreads less onto the substrate 4 than the initial monomer would spread. In other words, ink 1 is deposited as an initial low viscosity ink, with a viscosity specific to the monomer, and spreads as a viscous liquid / phase because of the start of reticulation. Moreover, since the initial monomer phase of ink 1 is of low viscosity, the ink 1 can be transported much easily through the microfluidic system 6 connected to the cantilever 2. In this way, the patterns deposited onto the substrate 4 have a smaller size / width than those obtained in similar deposition conditions but without photopolymerization.

In the other embodiment of optically assisted fountain pen nanolithography, the light beam 5 produces the fast evaporation of the solvent that, in some cases and for some applications, enters within the composition of the ink 1. Because of the fast solvent evaporation, ink 1 diffuses less onto the substrate 4. The solvent evaporation takes place as a consequence of ink 1 heating, the wavelength of the light beam 5 being chosen in such a way so as to heat ink 1. The solvent can be that used for dissolving a solid material into its liquid solvent, for example such as water for soluble salts or sugar, or the solvent can be that used for dissolving a liquid material, such as a liquid resin into its specific liquid solvent.

By using the known methods encountered in usual fountain pen nanolithography or dip pen nanolithography, the cantilever 2 and / or the substrate 4 are scanned / moved with respect to each other, with appropriate speed, in the plane of the substrate 4 so that the desired 2D pattern is obtained / drawn onto the surface. Moreover, the ink 1 pressure and flowrate through the microfluidic system 6 are tuned in such a way so as to obtain the desired width of the pattern. Additionally, the ink 1 temperature may be established in such a way so as to obtain the desired initial viscosity. Supplementary, the intensity of the light beam 5 is chosen in such a way so as to promote a faster or slower reticulation / evaporation of the ink 1, according to the needs.

In the case when 3D structures are envisioned, then the cantilever 2 will have a movement in the X-Y plane of the substrate 4 as well as a vertical movement along a Z direction perpendicular to the substrate 4. This vertical movement may be realized in three ways. In the first case, only the vertical movement produced by the piezoelectric actuators associated to the scanning system 3 is used. These actuators are specific to any types of atomic force microscopes. In the second case, a bimorph cantilever 2 is used. The bimorph cantilever bends in the vertical direction when its temperature is changed because of the different thermal expansion coefficients of the materials forming the bimorph structure. The variation of the bimorph cantilever 2 temperature is achieved either by Joule heating when an electric current passes through it or by the thermoelectric effect if the electric current passes through the junction of at least two dissimilar materials. Moreover, any other heating means can be used for that purpose. The bending of the cantilever 2 in the vertical plane gives rise to the up or down motion of the tip aperture through which ink 1 is exiting, according to the needs. In the third case, the vertical movement of the cantilever is achieved by a combination of the previous two ways, namely piezoelectric actuation and thermal bending of the bimorph cantilever 2.

The vertical speed of the cantilever 2 tip, the flowrate and initial viscosity of the ink 1 and the intensity of the light beam are correlated in such a way so as the 3D structure under building is not broken during the construction process and ink 1 does not flow around the structure margins.

The movement of the cantilever can be realized not only in the vertical Z direction but also on the directions X and Y by using the scanning system 3. Thus, one way of realizing the 3D structure is by moving the cantilever 2 in all direction XYZ with respect to the substrate 4 according to the geometry that has to be built, all the process being optically assisted by the light beam 5. A second way of realizing the 3D structure is the layer-by-layer deposition of ink 1 onto the substrate 4 simultaneously with illumination with the light beam 5, up to the moment when the full 3D structure is built. Choosing of one of the two ways of 3D construction depends on the concrete geometry of the 3D structure that has to be realized.

The light beam 5 is applied throughout the whole duration of ink 1 deposition and has an intensity so as to assure the optimum deposition process. The cantilever 2, which is opaque to the wavelength of light beam 5, can be moved also without depositing ink 1. This happens when moving between two positions in which it has not to deposit ink 1 or when passing from one written structure to the next structure that has to be written / deposited. The light beam 5 shines onto the substrate 4 in the deposition region from at least two different directions in such a way that, whichever the movement of cantilever 2, the light beam 5 reaches every time the ink 1 exiting from the tip of the cantilever 2.

As compared to other existing 3D rapid prototyping techniques such as fused deposition modeling or 3D printers based on photopolymerization, the beam 5 has the role to finely change the viscosity of ink 1 such that its diffusion over substrate 4 surface, respectively its deposition rate in the case of 3D building, is accomplished according to the needs. In the case of the mentioned 3D rapid prototyping techniques the role of the light beam used for photopolymerization or for heating is that of creating a solid object directly from the liquid monomer / polymer. In our case, we change the flow properties of ink 1 by controlling its viscosity through the photopolymerization, respectively solvent evaporation, rates. In this way we achieve a finer control of the deposition process both at 2D and 3D levels than that achieved in the existing 3D rapid prototyping techniques. In the case of 2D deposition, beam 5 controls the width of the 2D pattern, because a less viscous ink 1 diffuses more onto the substrate 4 surface than a more viscous ink. In the case of 3D deposition, beam 5 controls, together with the cantilever 2 speed, the size / diameter of the 3D structure.

A single cantilever 2 or an array of identical cantilevers 2 may be used for the 2D and 3D nanolithography process. These cantilevers 2 can be controlled independently or in a together manner and the use of such an array of cantilevers 2 allows the simultaneous deposition of ink 1 in several regions of substrate 4 thus enhancing the speed of the technological process, these cantilevers 2, placed nearby to each other or not, depositing, simultaneously or not, the same type of ink 1 or different types of ink 1.

In order to perform the deposition of ink 1, the cantilever 2 is slightly descended towards substrate 4 by one of the methods mentioned above for the vertical movement of cantilever 2. The descending of cantilever 2 continues until it enters into feedback according to the parameters indicated by the user. The method for detecting the entry into feedback is that encountered in existing atomic force microscopes. The deflection / bending of cantilever 2 is read by one of the known methods encountered in atomic force microscopy as are, for example, the tracking of the light beam reflected by the upper surface of the cantilever 2 or any other kind of optically reading small displacements the such as diffractive or interference based methods. In these cases of optical reading, the light beam used for reading / tracking the cantilever displacement must not influence the deposition process. In other words, it must neither promote photopolymerization of nor heat the ink 1. Moreover, the deflection of cantilever 2 may be read also piezoresistively by reading the variation of resistivity of a specific material that is mounted in a specific position on cantilever 2, resistivity variation due to the bending of the cantilever 2. Additionally, the deflection of the cantilever 2 may be read capacitively or inductively or in any other manner that is known.

The 2D and 3D light assisted fountain nanolithography may be performed either in constant force mode or in constant height mode. This two working methods are defined according to their meaning in atomic force microscopy.

One way of performing the method for 2D and 3D light assisted fountain pen nanolithography is that when cantilever 2, being in feedback, follows the topography of substrate 4 in real-time and corrects its position against substrate 4 in an appropriate manner specific to the parameters indicated by the user. This is possible by real-time tracking of the cantilever 2 bending and by maintaining its deflection at the value set by the user using the feedback loop of the system. This way of performing the 2D and 3D nanolithography process is that specific to the constant force mode commonly encountered in atomic force microscopy.

An alternative way to perform the 2D and 3D light assisted fountain pen nanolithography is to scan the substrate 4 first. This first scanning of the substrate 4 is made by using a common cantilever as those used for obtaining surface topography in atomic force microscopy, cantilever that has a sharp and un-perforated tip. This first surface scan is made in constant force mode for achieving the surface topography of the substrate 4. The surface topography of substrate 4 is thus obtained with good spatial resolution. This atomic force imaging cantilever may be integrated near the cantilever 2 onto the same chip. A second scan is then performed in constant height mode for the same region of substrate 4 in order to establish the position of the X-Y scanning plane with respect to substrate 4. By using the data obtained from the two scans, the computer that controls the overall system computes the way in which cantilever 2, after being in feedback, must be moved in the vertical direction during deposition of ink 1 so as to compensate the variations of surface topography of substrate 4. This alternative way of performing the process is more indicated since it does not imply the real-time monitoring of the surface topography during the ink 1 deposition process. This is an advantage because, during the deposition process of ink 1, the cantilever 2 is bent not only by the forces acting between substrate 4 and it but also by the capillary forces produced by ink 1 so that the determination of substrate 4 surface topography is less accurate.

Ink 1 can be a monomer, a monomer into a solvent, a monomer mixed with other organic substances with or without solvents, a monomer or any other sort of liquid that contains a colloid of nanoparticles. These nanoparticles can be, without restricting their type, metallic or semiconducting or insulator as regards their electric properties. Moreover, these nanoparticles may have specific magnetic and / or optical properties. In another situation, ink 1 may be formed by a soluble solid substance dissolved in specific solvent or, in another case, an organic or inorganic liquid dissolved in another liquid substance miscible with it.

The composition of ink 1 may vary during the deposition process by using a microfluidic mixer placed in the microfluidic chip 6, mixer that mixes two or more types of ink 1 in the proportions desired by the user, proportions that vary during the deposition of the mixed ink 1 onto the substrate 4.

The flow of ink 1 through the exit aperture of cantilever 2 tip may be continuous, intermittent or as drops separated by gas bubbles, according to the needs, in the continuous case having either a constant flowrate or a flowrate modulated in time according to a desired law of variation with time

The 2D and 3D light assisted nanolithography process is executed in such a way so as there is a permanent correlation between the speed of cantilever 2, the flowrate and viscosity of ink 1 and the illumination intensity of light beam 5 so that the deposition of ink 1 is made in optimum conditions, without breaking unintentionally the flux of ink 1 and without the existence of phenomena that degrade the quality of the obtained structures. A calibration may be done in some cases prior to the deposition process, calibration that is achieved by drawing lines or other planar, respectively 3D spatial, structures that are deposited at different speeds of the cantilever 2 and at different flowrates of ink 1 and at different intensities of light beam 5. From this calibration process are obtained data that are used for the correct construction of the desired patterns by the subsequent nanolithography process. The calibration process may also take into account the effect of the substrate and environment temperatures, respectively, as well as the effect of the relative humidity of the working environment.

The calibration for the 2D lithography, in one of the cases, is performed in the following way:
- cantilever 2 is brought in the close vicinity of the substrate 4 surface, preferably entering into feedback
- ink 1 reaches the substrate 4 surface due to a liquid meniscus formation or by applying a very slight pressure on it from the micropump of microfluidic chip 6
- lines are drawn onto substrate 4 surface in different locations, each line at a specific value of ink 1 flowrate, cantilever 2 horizontal speed and beam 5 intensity
- the lines such drawn are imaged by AFM and, from the AFM images thus acquired, their width is measured
- the values of the widths are fit as a function of ink 1 flowrate, cantilever 2 horizontal speed and beam 5 intensity, a mathematical relation between linewidth and said parameters resulting from the said fit
- the obtained mathematical relation is used further when performing nanolithography in order to establish the appropriate values for ink 1 flowrate, cantilever 2 horizontal speed and beam 5 intensity so as to obtain the desired linewidth

The calibration for the 2D lithography, in a second case, is performed, in the following way:
- cantilever 2 is brought in the close vicinity of the substrate 4 surface, preferably entering into feedback
- ink 1 reaches the substrate 4 surface due to a liquid meniscus formation or by applying a very slight pressure on it from the micropump of microfluidic chip 6
- cantilever 2 is kept fixed in the position for a certain time interval called dwell time, so as ink 1 spreads over the substrate 4 surface for specified values of ink 1 flowrate, dwell time interval and beam 5 intensity, thus obtaining a dot-like pattern having a certain diameter
- the method is repeated in another location for different values of ink 1 flowrate, cantilever 2 dwell time and beam 5 intensity
- the dot patterns thus obtained are imaged by AFM and, from the AFM images, their diameters are measured
- the values of the diameters are fit as a function of ink 1 flowrate, cantilever 2 dwell time and beam 5 intensity, a mathematical relation between diameter and said parameters resulting from the said fit
- the obtained mathematical relation is used further when performing nanolithography in order to establish the appropriate values for ink 1 flowrate, cantilever 2 dwell time and beam 5 intensity so as to obtain the desired diameter of the pattern

The calibration for the 2D lithography, in a third case, is performed by using a combination of previous two calibration processes mentioned for the 2D case.

The calibration process for the 3D lithography is performed, in a first case, in the following way:
- cantilever 2 is brought in close proximity to substrate 4, preferably entering into feedback regime, so as ink 1 reaches substrate 4 surface due either to a liquid meniscus formed between the tip of cantilever 2 and substrate 4 or to a very slight pressure applied to the ink 1 by the micropump contained by the microfluidic chip 6
- cantilever 2 is lifted along the vertical Z direction with a specified vertical speed while ink 1, having a specified flowrate, exits from the tip aperture of cantilever 2 being simultaneously illuminated by the beam 5 that has a specified intensity and, thus, a column of material having a certain height is created
- the process is repeated, in different places of the substrate 4, for different values of ink 1 flowrate, cantilever 2 vertical speed and beam 5 intensity
- the heights and diameters of the columns are measured by using the known means of measuring size at the micro- and nanoscale
- the values of the diameters and, respectively, heights, are fit as a function of ink 1 flowrate, cantilever 2 vertical speed and beam 5 intensity, a mathematical relation resulting from this fit that correlates column diameter, respectively column height to the said parameters.
- the obtained mathematical relation is used further when performing 3D building nanolithography in order to establish the appropriate values for ink 1 flowrate, cantilever 2 vertical speed and beam 5 intensity so as to obtain the desired diameter and height for the column

The calibration process for the 3D lithography is performed, in a second case, in the following way:
- a number of vertical columns, normal to substrate (4) surface, are first created, placed at a specified distance onto substrate 4
- cantilever 2 is brought at top of one of these columns up to the moment when ink 1, due to a liquid meniscus formation or to a very slight pressure applied to it, reaches the respective column and then moving it horizontally in the XY plane with a specified cantilever 2 horizontal speed, with a specified ink 1 flowrate and specified beam 5 intensity in order to create a horizontal structure supported at one of its ends by the respective column and having a length chosen by the user
- the process is repeated starting from the top of another column and using different cantilever 2 horizontal speed, ink 1 flowrate and beam 5 intensity, thus being created a novel suspended horizontally structure
- the widths / diameters of the suspended horizontally structures are measured by using known techniques of size measurement at the micro- and nanoscale
- the values of the widths / diameters are fit as a function of ink 1 flowrate, cantilever 2 horizontal speed and beam 5 intensity, a mathematical relation resulting from this fit that correlates column diameter / widths to the said parameters
- the obtained mathematical relation is used further when performing 3D building nanolithography in order to establish the appropriate values for ink 1 flowrate, cantilever 2 horizontal speed and beam 5 intensity so as to obtain the desired sizes of the horizontally suspended lines

The calibration process for the 3D lithography is performed, in a third case, in the following way:
- cantilever 2 is brought in close proximity of substrate 4, preferably entering into feedback regime, so as ink 1 reaches substrate 4 surface
- cantilever 2 is lifted along the vertical Z direction with a specified vertical speed simultaneously moving it also in the horizontal XY plane with another specified speed while ink 1, having a specified flowrate, exits from the tip aperture of cantilever 2 simultaneously with beam 5 illuminating it and thus creating a column of material inclined at a certain angle with respect to substrate 4 surface

- the process is repeated in different places of the substrate 4, for different values of ink 1 flowrate, cantilever 2 vertical and horizontal speeds, respectively beam 5 intensity
- the size and inclination of the realized inclined columns are measured by using known techniques of size measurement at the micro- and nanoscale
- the size and, respectively, the inclination angle are fit as a function of the of ink 1 flowrate, cantilever 2 horizontal and vertical speeds and beam 5 intensity, thus a mathematical relation resulting from this fit that correlates column diameter, respectively column inclination angle, to the said parameters
- the obtained mathematical relation is used further when performing 3D building nanolithography in order to establish the appropriate values for ink 1 flowrate, cantilever 2 horizontal and vertical speeds and beam 5 intensity so as to obtain the desired sizes and inclination angles for the inclined columns

The calibration for the 3D lithography, in a fourth case, is performed by using a combination of previous three calibration processes mentioned for the 3D case.

Moreover, all of the 2D and 3D calibration methods mentioned above are made for different values of ink (1) initial viscosity. In all the calibration cases mentioned above, the flowrate of ink 1 is established in all cases by the micropump contained in the microfluidic chip 6 that is feeding the channel directly linked to the exit aperture of the cantilever 2 tip.

The 2D and 3D light assisted fountain pen nanolithography process may be done in normal air or in a controlled atmosphere or in vacuum, according to the needs and to the properties of ink 1. By controlled atmosphere we understand an atmosphere whose composition, pressure, temperature and humidity are controlled. The composition may be formed by one or several gases / vapours of different substances. The pressure may range in the 10⁻¹² Torr - 10 atm interval. The temperature may range from -200° C to 1000° C. The relative humidity may vary between 0,01 % and 99 %.

The cantilever speed in the X-Y / horizontal plane is between 0,001 micron/sec and 1000 micron/sec. The cantilever speed in the Z / vertical direction is from 0,001 micron/sec to 1000 micron/sec.

For the case when the beam 5 is used for the photopolymerization of ink 1, its wavelength is contained in the 150 nm - 650 nm spectral range, its intensity lies in the 1 pW/cm² - 10 MW/cm² interval, the beam 5 being either of the continuous wave type or of quasi-continuous wave type or in pulses, pulses whose duration lies between 1 fsec - 100 msec and pulse repetition frequency lies in the 0,1 Hz - 100 MHz interval, the energy per pulse being between 1 pJ - 1 J, the beam 5 being either coherent or partially coherent or incoherent.

For the case when beam 5 is used for evaporating the solvent contained in the ink 1 composition, its wavelength is contained in the 150 nm - 15000 nm spectral range, its intensity is between 1 pW/cm² - 10 GW/cm², the beam 5 being either of the continuous wave type or of quasi-continuous wave or in pulses, pulses whose duration lies between 1 fsec - 100 msec and pulse repetition frequency lies in the 0,1 Hz - 100 MHz interval, the energy per pulse being between 1 pJ - 100 J, the beam 5 being either coherent or partially coherent or incoherent.

The flowrate of ink 1 in the microfluidic channel that is directly feeding the tip aperture of cantilever 2 is between 10⁻³⁰ m³/sec and 10⁻⁹ m³/sec.

We present in the following embodiments of the invention.

In a first embodiment, ink 1 is a photoresist monomer as those used in optical lithography when fabricating integrated circuits. This photoresist is sensitive to the blue part of the visible spectrum. This photoresist is deposited with a perforated cantilever 2 having an aperture of 20 nm at its tip, the photoresist exiting from this tip aperture and being deposited onto substrate 4. Substrate 4 is Silicon. The light beam has a wavelength of 450 nm, an intensity of 5 W/cm² and is applied during the deposition process, photopolymerizing the photoresist represented by ink 1. The deposition is 2D onto the substrate surface or is 3D, depending on the needs.

In a second embodiment, ink 1 is polymer dissolved in its specific solvent. An example is polystyrene dissolved in acetone. The light beam 5 is in the infrared range of the spectrum having a wavelength of 2,5 micron. The light beam 5 produces the heating of ink 1 and, thus, the accelerated evaporation of the solvent.

In a third embodiment, ink 1 is made of a soluble salt such as ZnS dissolved in water. In this case, the light beam 5 is in the infrared range of the spectrum, having a wavelength of 5 micron. The ink 1 is thus heated by the infrared beam 5 and water is thus evaporated in an accelerated way.

In a fourth embodiment, ink 1 is formed by a mixture of soluble salts, such as ZnS and CdS dissolved in water. The light beam 5 is in the infrared range of the spectrum, having a wavelength of 5 micron. Ink 1 is thus heated by the infrared beam 5 and water is thus evaporated in an accelerated way. The deposition is made in such a way that the composition of the remaining salt mixture deposited onto substrate 4 made of Silicon dioxide, after the accelerated evaporation of water, varies along the deposition direction.

In a fifth embodiment, ink 1 consists in a mixture of a known photoresist solution and a colloid containing Ag nanoparticles, the photoresist solution and the colloid being miscible. The deposition of ink 1 is assisted optically by a blue light beam 5 that produces the photopolymerization of the photoresist. Thus, a polymer-Ag nanoparticles composite is obtained.

## Claims

1. A method of 2D and 3D optically assisted fountain pen nanolithography and aperture pen nanolithography, comprising : depositing an ink (1) onto a surface of a substrate (4) by using either a fountain pen or an aperture pen cantilever (2) that is moving with appropriate speed horizontally and/or vertically with respect to surface of the substrate (4), the cantilever (2) having an inner channel connected to a microfluidic chip (6) that feeds with ink (1) the aperture at its tip while a light beam (5) is applied on the deposition region, the beam (5) having the role either of initiating the photopolymerization of the ink (1) when the ink (1) contains a photopolymerizable substance in its composition or of accelerating the evaporation of a solvent that enters into the composition of the ink (1), in both cases the effect of the beam (5) being that of finely controlling the viscosity of the ink (1) in order to achieve a desired diffusion coefficient of the ink (1) onto the surface of substrate (4), respectively of achieving the desired 3D deposition rate of the ink (1), the light beam (5) being applied from at least two different directions so that, whichever is the position and movement of the cantilever (2) in space, the light beam (5) reaches the ink (1) in the deposition region of the substrate.

2. A method of 2D and 3D optically assisted fountain pen nanolithography and aperture pen nanolithography according to claim 1, further comprising : real-time tracking of the substrate (4) surface topography during the deposition process in order to compensate any height variation of the substrate (4).

3. A method of 2D and 3D optically assisted fountain pen nanolithography and aperture pen nanolithography according to claim 1, further comprising : compensating the substrate (4) surface topography variation by obtaining first the surface topography of the substrate (4) with an atomic force microscopy scan of the work region and then performing the 2D and/or 3D building process by taking into account the substrate (4) topographic data.

4. A method of 2D and 3D optically assisted fountain pen nanolithography and aperture pen nanolithography according to claim 1, further comprising : reading of the bending of the cantilever (2) by any of the known means in atomic force microscopy, namely optically, piezoresistively, capacitevely, inductively, with the provision that in the case of optical reading the light beam used for tracking the cantilever displacement neither promote photopolymerization of nor heats the ink (1).

5. A method of 2D and 3D optically assisted fountain pen nanolithography and aperture pen nanolithography according to claim 1, further comprising : using a single cantilever (2) or an array of cantilevers (2) integrated onto the same chip, each cantilever (2) of the array being actuated either independently or together with other cantilevers and depositing the same type of ink (1) as other cantilevers or a different type of ink (1).

6. A method of 2D and 3D optically assisted fountain pen nanolithography and aperture pen nanolithography according to claim 1, further comprising : realizing the 2D patterns either by moving the cantilever (2) horizontally with respect to the surface of the substrate (4) with an appropriate speed or by letting the cantilever (2) stay a certain time interval called dwell time in the immediate proximity of the surface of the substrate (4) so that the ink (1) reaches the surface of the substrate (4) and then spreads over it.

7. A method of 2D and 3D optically assisted fountain pen nanolithography and aperture pen nanolithography according to claim 1, further comprising : building the 3D structure by moving the cantilever (2) along the spatial coordinates X, Y, Z, by using methods and scanning systems (3) known in atomic force microscopy.

8. A method of 2D and 3D optically assisted fountain pen nanolithography and aperture pen nanolithography according to claim 1, further comprising : building the 3D structure by a layer-by-layer deposition of the ink (1), each layer being horizontal with respect to the substrate (4) surface and made by a deposition process specific to 2D pattern construction while the layers placement atop each other being along the vertical Z axis until the desired 3D structure is obtained.

9. A method of 2D and 3D optically assisted fountain pen nanolithography and aperture pen nanolithography according to claims 7 or 8 further comprising : building the 3D structure by a combination of moving the cantilever (2) along the X, Y, Z spatial coordinates by using methods and scanning systems (3) known in atomic force microscopy and a layer-by-layer deposition of the ink (1).

10. A method of 2D and 3D optically assisted fountain pen nanolithography and aperture pen nanolithography according to claim 1, further comprising : achieving a vertical movement of the cantilever (2) by means of a known piezoelectric actuating system included in the scanning system (3) and specific to any type of atomic force microscopes.

11. A method of 2D and 3D optically assisted fountain pen nanolithography and aperture pen nanolithography according to claim 1, further comprising : achieving the vertical movement of the cantilever (2), wherein the cantilever (2) is bimorph, by variation of the cantilever (2) temperature through any known heating means and methods.

12. A method of 2D and 3D optically assisted fountain pen nanolithography and aperture pen nanolithography according to claim 11, further comprising : obtaining the variation of the cantilever (2) temperature either by Joule heating or by thermoelectric effect.

13. A method of 2D and 3D optically assisted fountain pen nanolithography and aperture pen nanolithography according to claims 10 or 11 further comprising : achieving the vertical movement of the cantilever (2), wherein the cantilever (2) is bimorph, by a combination of piezoelectric actuation and thermal bending of the cantilever (2) giving rise to the up or down motion of the cantilever (2) tip aperture with respect to the substrate (4).

14. A method of 2D and 3D optically assisted fountain pen nanolithography and aperture pen nanolithography according to claim 1, further comprising : correlating the cantilever (2) speed, flowrate of the ink (1) and intensity of the light beam (5) such that the deposition of the ink (1) is made in optimum conditions without unintentionally breaking or interrupting the 2D patterns and 3D structures that are realized.

15. A method of 2D and 3D optically assisted fountain pen nanolithography and aperture pen nanolithography according to claim 1, further comprising : providing the flow of the ink (1) either as continuous or intermittent or as drops separated by gas bubbles, in the continuous case having either a constant flowrate or a flowrate modulated in time .

16. A method of 2D and 3D optically assisted fountain pen nanolithography and aperture pen nanolithography according to claim 1, further comprising : providing the ink (1) as a photopolymerizable monomer.

17. A method of 2D and 3D optically assisted fountain pen nanolithography and aperture pen nanolithography according to claim 1, further comprising : providing the ink (1) as a monomer or a polymer in a solvent solution.

18. A method of 2D and 3D optically assisted fountain pen nanolithography and aperture pen nanolithography according to claim 1, further comprising : providing the ink (1) as a monomer or a polymer mixed with other organic substances .

19. A method of 2D and 3D optically assisted fountain pen nanolithography and aperture pen nanolithography according to claim 1, further comprising : providing the ink (1) as a monomer, a solution of polymer or any other liquid that contains nanoparticles having specific electric and/or magnetic and/or optical properties.

20. A method of 2D and 3D optically assisted fountain pen nanolithography and aperture pen nanolithography according to claim 1, further comprising : forming the ink (1) by a solid substance dissolved in its specific solvent or by a liquid organic or inorganic substance dissolved into another liquid substance that is miscible with it.

21. A method of 2D and 3D optically assisted fountain pen nanolithography and aperture pen nanolithography according to claim 1, further comprising : varying the composition of the ink (1) during the deposition process by using a microfluidic mixer placed inside the chip (6), the mixer mixing in the desired proportion at least two different types of ink (1).

22. A method of 2D and 3D optically assisted fountain pen nanolithography and aperture pen nanolithography according to claim 1, further comprising : performing the nanolithography process in normal air or in a controlled atmosphere as regards composition and physical properties or in vacuum, at pressure in the range 10⁻¹² Torr - 10 atm, temperature in the range -200° C - 1000° C and relative humidity in the range 0,01 % - 99 %.

23. A method of 2D and 3D optically assisted fountain pen nanolithography and aperture pen nanolithography according to claim 1, further comprising : providing the cantilever speed in the horizontal plane in the range 0,001 micron/sec - 1000 micron/sec while the cantilever speed in the vertical direction is in the range 0,001 micron/sec - 1000 micron/sec.

24. A method of 2D and 3D optically assisted fountain pen nanolithography and aperture pen nanolithography according to claim 1, further comprising : providing the beam (5), when used for photopolymerization of the ink (1), with a wavelength contained in the spectral range 150 nm - 650 nm its intensity lying in the range 1 pW/cm² - 10 MW/cm², the beam (5) being either of the continuous wave or quasi-continuous wave type or in pulses, pulses whose duration lies in the range 1 fsec - 100 msec and have a pulse repetition frequency in the range 0,1 Hz - 100 MHz , the energy per pulse being in the range 1 pJ - 1 J, and having any possible state of coherence.

25. A method of 2D and 3D optically assisted fountain pen nanolithography and aperture pen nanolithography according to claim 1, further comprising : providing the beam (5), when used for evaporating the solvent contained in the ink (1) composition, with a wavelength contained in the spectral range 150 nm - 15000 nm, its intensity being in the range 1 pW/cm² - 10 GW/cm², the beam (5) being either of the continuous wave type or of quasi-continuous wave or in pulses, pulses whose duration lies in the range 1 fsec - 100 msec and pulse repetition frequency lies in the range 0,1 Hz - 100 MHz , the energy per pulse being in the range 1 pJ - 100 J, and having any possible state of coherence.

26. A method of 2D and 3D optically assisted fountain pen nanolithography and aperture pen nanolithography according to claim 1, further comprising : providing the flowrate of the ink (1) in the range 10⁻³⁰ m³/sec - 10⁻⁹ m³/sec, in the microfluidic channel that is directly feeding the tip aperture of the cantilever (2).

27. A method of 2D and 3D optically assisted fountain pen nanolithography and aperture pen nanolithography according to claim 1, further comprising : realizing the deposition either directly or using a previous calibration process of the ink (1) deposition in 2D and in 3D, calibration process aimed at assuring the best combination of parameters, such as ink (1) flowrate, cantilever (2) horizontal and vertical speeds and beam (5) intensity.

28. A method of 2D and 3D optically assisted fountain pen nanolithography and aperture pen nanolithography according to claim 27, wherein the calibration for the 2D lithography further comprises the following steps :
- bringing the cantilever (2) in the close vicinity of the substrate (4) surface, preferably entering into feedback
- making the ink (1) reach the substrate (4) surface due to a liquid meniscus formation or by applying a very slight pressure on it from the micropump of the microfluidic chip (6)
- drawing lines onto the substrate (4) surface in different locations, each line at a specific value of ink (1) flowrate, cantilever (2) horizontal speed and beam (5) intensity
- imaging the drawn lines by AFM and, from the AFM images thus acquired, measuring their width
- fitting the values of the widths as a function of ink (1) flowrate, cantilever (2) horizontal speed and beam (5) intensity, a mathematical relation between linewidth and said parameters resulting from the said fit
- further using the obtained mathematical relation when performing nanolithography in order to establish the appropriate values for ink (1) flowrate, cantilever (2) horizontal speed and beam (5) intensity so as to obtain the desired linewidth

29. A method of 2D and 3D optically assisted fountain pen nanolithography and aperture pen nanolithography according to claims 27, wherein the calibration for the 2D lithography further comprises the following steps :
- bringing the cantilever (2) in the close vicinity of the substrate (4) surface, preferably entering into feedback
- making the ink (1) reach the substrate (4) surface due to a liquid meniscus formation or by applying a very slight pressure on it from the micropump of the microfluidic chip (6)
- keeping the cantilever (2) fixed in the position for a certain time interval called dwell time, so as the ink (1) spreads over the substrate (4) surface for specified values of ink (1) flowrate, dwell time interval and beam (5) intensity, thus obtaining a dot-like pattern having a certain diameter
- repeating the previously mentioned three steps in another location for different values of ink (1) flowrate, cantilever (2) dwell time and beam (5) intensity
- imaging the dot patterns thus obtained by AFM and, from the AFM images, measuring their diameters
- fitting the values of the diameters as a function of ink (1) flowrate, cantilever (2) dwell time and beam (5) intensity, a mathematical relation between diameter and said parameters resulting from the said fit
- further using the obtained mathematical relation when performing nanolithography in order to establish the appropriate values for ink (1) flowrate, cantilever (2) dwell time and beam (5) intensity so as to obtain the desired diameter of the pattern.

30. A method of 2D and 3D optically assisted fountain pen nanolithography and aperture pen nanolithography according to any of the claims 27-29 further comprising : making use, in the calibration process for the 2D litography, of both the calibration of the linewidth and of dot diameter in order to obtain the appropriate sizes of the different patterns realized onto the substrate (4) surface.

31. A method of 2D and 3D optically assisted fountain pen nanolithography and aperture pen nanolithography according to claim 27, wherein the calibration process for the 3D lithography further comprises the following steps :
- bringing the cantilever (2) in close proximity to the substrate (4), preferably entering into feedback regime,
- making the ink (1) reach the substrate (4) surface due either to a liquid meniscus formed between the tip of cantilever (2) and the substrate (4) or to a very slight pressure applied to the ink (1) by the micropump contained by the microfluidic chip (6)
- lifting the cantilever (2) along the vertical Z direction with a specified vertical speed while the ink (1), having a specified flowrate, exits from the tip aperture of the cantilever (2) being simultaneously illuminated by the beam (5) that has a specified intensity and, thus, creating a column of material having a certain height
- repeating the previous steps, in different places of the substrate (4), for different values of ink (1) flowrate, cantilever (2) vertical speed and beam (5) intensity
- measuring the heights and diameters of the columns by using the known means of measuring size at the micro- and nanoscale
- fitting the values of the diameters and, respectively, of the heights, as a function of ink (1) flowrate, cantilever (2) vertical speed and beam (5) intensity, a mathematical relation resulting from this fitting that correlates column diameter, respectively column height to the said parameters.
- further using the obtained mathematical relation when performing 3D building nanolithography in order to establish the appropriate values for ink (1) flowrate, cantilever (2) vertical speed and beam (5) intensity so as to obtain the desired diameter and height for the column

32. A method of 2D and 3D optically assisted fountain pen nanolithography and aperture pen nanolithography according to claim 27, wherein the calibration process for the 3D lithography further comprises the following steps :
- creating a number of vertical columns, normal to the substrate (4) surface, placed at a specified distance onto the substrate (4)
- bringing the cantilever (2) at the top of one of these columns up to the moment when the ink (1), due to a liquid meniscus formation or to a very slight pressure applied to it, reaches the respective column and then moving it horizontally in the XY plane with a specified cantilever (2) horizontal speed, with a specified ink (1) flowrate and specified beam (5) intensity in order to create a horizontal structure supported at one of its ends by the respective column and having a length chosen by the user
- repeating the process starting from the top of another column and using different cantilever (2) horizontal speed, ink (1) flowrate and beam (5) intensity, thus creating a novel horizontally suspended structure
- measuring the widths / diameters of the suspended horizontally structures by using known techniques of size measurement at the micro- and nanoscale
- fitting the values of the widths / diameters as a function of ink (1) flowrate, cantilever (2) horizontal speed and beam (5) intensity, a mathematical relation resulting from this fit that correlates column diameter / widths to the said parameters
- further using the obtained mathematical relation when performing 3D building nanolithography in order to establish the appropriate values for ink (1) flowrate, cantilever (2) horizontal speed and beam (5) intensity so as to obtain the desired sizes of the horizontally suspended lines

33. A method of 2D and 3D optically assisted fountain pen nanolithography and aperture pen nanolithography according to claim 27, wherein the calibration process for the 3D lithography further comprises the following steps :
- bringing the cantilever (2) in close proximity of the substrate (4), preferably entering into feedback regime, so as the ink (1) reaches substrate (4) surface
- lifting the cantilever (2) along the vertical Z direction with a specified vertical speed simultaneously moving it also in the horizontal XY plane with another specified speed while the ink (1), having a specified flowrate, exits from the tip aperture of the cantilever (2) simultaneously with the beam (5) illuminating it and thus creating a column of material inclined at a certain angle with respect to the substrate (4) surface
- repeating the process in different places of the substrate (4), for different values of ink (1) flowrate, cantilever (2) vertical and horizontal speeds, respectively beam (5) intensity
- measuring the size and inclination of the realized inclined columns by using known techniques of size measurement at the micro- and nanoscale
- fitting the size and, respectively, the inclination angle as a function of ink (1) flowrate, cantilever (2) horizontal and vertical speeds and beam (5) intensity, obtaining thus a mathematical relation resulting from this fit that correlates column diameter, respectively column inclination angle, to the said parameters
- further using the obtained mathematical relation when performing 3D building nanolithography in order to establish the appropriate values for ink (1) flowrate, cantilever (2) horizontal and vertical speeds and beam (5) intensity so as to obtain the desired sizes and inclination angles for the inclined columns

34. A method of 2D and 3D optically assisted fountain pen nanolithography and aperture pen nanolithography according to claim 27, further comprising : achieving the calibration method for 3D case by a combination of two or more of the 3D calibration methods according to claims 31, 32 or 33.

35. A method of 2D and 3D optically assisted fountain pen nanolithography and aperture pen nanolithography according to any of the claims 27-34 further comprising : realizing the 2D calibration methods and 3D calibration methods for different values of ink (1) initial viscosity, having the flowrate of ink (1) determined by the micropump contained within the microfluidic chip (6) that feeds with ink (1) the microfluidic channel directly linked to the exit aperture of the cantilever (2) tip.

## Patentansprüche

1. Verfahren zur 2D- und 3D- optisch unterstützten Füllfederhalter-Nanolithographie und Blende-Nanolithographie, umfassend: die Ablagerung einer Tinte (1) auf einem Substrat (4) unter Verwendung eines Füllfederhalters oder eines Öffnungsstiftkragarms (2), der sich mit geeigneter Geschwindigkeit horizontal und/oder vertikal bezüglich der Oberfläche des Substrats (4) bewegt, wobei der Öffnungsstiftkragarm (2) einen inneren Kanal aufweist, der mit einem mikrofluidischen Chip (6) verbunden ist, der die Öffnung an seiner Spitze mit Tinte (1) versorgt, während ein Lichtstrahl (5) auf den Ablagerungbereich aufgebracht wird, wobei der Lichtstrahl (5) entweder die Photopolymerisation der Tinte (1) initiiert, wenn die Tinte (1) eine photopolymerisierbare Substanz in ihrer Zusammensetzung enthält oder die Verdampfung eines Lösungsmittels beschleunigt, das in die Zusammensetzung der Tinte (1) eintritt, wobei in beiden Fällen die Wirkung des Lichtstrahls (5) die feine Steuerung der Viskosität der Tinte (1) ist, um einen gewünschten Diffusionskoeffizienten der Tinte (1) auf der Oberfläche des Substrats (4) zu erreichen, und zwar die gewünschte 3D-Ablagerungsrate der Tinte (1) zu erreichen, wobei der Lichtstrahl (5) aus mindestens zwei verschiedenen Richtungen aufgebracht wird, so dass, egal welche Position und Bewegung der Öffnungsstiftkragarm (2) im Raum hat, der Lichtstrahl (5) die Tinte (1) in dem Ablagerungsbereich des Substrats erreicht.

2. Verfahren zur 2D- und 3D- optisch unterstützter Füllfederhalter-Nanolithographie und Blende-Nanolithographie nach Anspruch 1 ferner umfassend: Echtzeit-Tracking der Oberflächentopographie des Substrats (4) während des Ablagerungverfahrens, um jegliche Höhenschwankung des Substrats (4) zu kompensieren.

3. Verfahren zur 2D- und 3D- optisch unterstützter Füllfederhalter-Nanolithographie und Blende-Nanolithographie nach Anspruch 1 ferner umfassend: Kompensieren der Oberflächentopographie des Substrats (4), indem man zuerst die Oberflächentopographie des Substrats (4) mit einem Rasterkraftmikroskpie-Scan des Arbeitsbereichs erhält und dann den 2D- und/oder 3D- Bauvorgang unter Berücksichtigung der topographischen Daten des Substrats (4) durchführt.

4. Verfahren zur 2D- und 3D- optisch unterstützter Füllfederhalter-Nanolithographie und Blende-Nanolithographie nach Anspruch 1 ferner umfassend: Ablesen der Biegung des Öffnungsstiftkragarms (2) durch irgendeines der in der Atomkraftmikroskopie bekannten Mittel nämlich optisch, piezoresistiv, kapazitiv, induktiv, mit der Maßgabe, dass bei der optischen Ablesung der zur Verfolgung der Auslegerversetzung verwendete Lichtstrahl weder die Photopolymerisation der Tinte (1) fördern noch erhitzen kann.

5. Verfahren zur 2D- und 3D- optisch unterstützter Füllfederhalter-Nanolithographie und Blende-Nanolithographie nach Anspruch 1 ferner umfassend: Verwendung eines einzigen Öffnungsstiftkragarms (2) oder einer Anordnung von Öffnungsstiftkragarme (2), die auf demselben Chip integriert sind, wobei jeder Öffnungsstiftkragarm (2) der Anordnung entweder unabhängig oder zusammen mit anderen Öffnungsstiftkragarmen betätigt wird und Abscheiden derselben Tintenart (1) als andere Öffnungsstiftkragarme oder einer anderen Tintenart (1).

6. Verfahren zur 2D- und 3D- optisch unterstützter Füllfederhalter-Nanolithographie und Blende-Nanolithographie nach Anspruch 1 ferner umfassend: Herstellung der 2D-Muster entweder durch horizontales Bewegen des Öffnungsstiftkragarms (2) in Bezug auf die Oberfläche des Substrats (4) mit einer geeigneten Geschwindigkeit oder indem der Öffnungsstiftkragarm (2) in der unmittelbaren Nähe der Oberfläche des Substrats (4) ein bestimmtes Zeitintervall, Verzweifelzeit genannt, verbleibt, so dass die Tinte (1) die Oberfläche des Substrats (4) erreicht und sich dann darüber ausbreitet.

7. Verfahren zur 2D- und 3D- optisch unterstützter Füllfederhalter-Nanolithographie und Blende-Nanolithographie nach Anspruch 1 ferner umfassend: Aufbauen der 3D-Struktur durch Verschieben des Öffnungsstiftkragarms (2) entlang der Raumkoordinaten X, Y, Z, unter Verwendung von in der Rasterkraftmikroskopie bekannten Verfahren und Abtastsysteme (3).

8. Verfahren zur 2D- und 3D- optisch unterstützter Füllfederhalter-Nanolithographie und Blende-Nanolithographie nach Anspruch 1 ferner umfassend: Aufbauen der 3D-Struktur durch schichtweises Ablegen der Tinte (1), wobei jede Schicht bezüglich der Oberfläche des Substrats (4) horizontal ist und durch einen Ablegprozess gebildet wird, der für eine 2D-Musterkonstruktion spezifisch ist, während die Lage der übereinander liegenden Schichten entlang der vertikalen Achse Z ist, bis die gewünschte 3D-Struktur erhalten wird.

9. Verfahren zur 2D- und 3D- optisch unterstützter Füllfederhalter-Nanolithographie und Blende-Nanolithographie nach Anspruch 7 oder 8 ferner umfassend: Aufbauen der 3D-Struktur durch eine Kombination des Bewegens des Öffnungsstiftkragarms (2) entlang der räumlichen Koordinaten X, Y, Z unter Verwendung von in der Rasterkraftmikroskopie bekannten Verfahren und Abtastsystemen (3) und des schichtweisen Ablegens der Tinte (1).

10. Verfahren zur 2D- und 3D- optisch unterstützter Füllfederhalter-Nanolithographie und Blende-Nanolithographie nach Anspruch 1 ferner umfassend: Erreichung einer vertikalen Bewegung des Öffnungsstiftkragarms (2) mittels eines bekannten piezoelektrischen Betätigungssystems das in dem Abtastsystem (3) enthalten ist und für jeden Typ von Atomkraftmikroskopen spezifisch ist.

11. Verfahren zur 2D- und 3D- optisch unterstützter Füllfederhalter-Nanolithographie und Blende-Nanolithographie nach Anspruch 1 ferner umfassend: Erreichung der vertikalen Bewegung des Öffnungsstiftkragarms (2), wobei der Öffnungsstiftkragarm (2) biomorph, durch Variation der Temperatur des Öffnungsstiftkragarms (2) durch beliebige bekannnte Heizmittel und Verfahren, ist.

12. Verfahren zur 2D- und 3D- optisch unterstützter Füllfederhalter-Nanolithographie und Blende-Nanolithographie nach Anspruch 11 ferner umfassend: Erhalten der Variation der Temperatur des Öffnungsstiftkragarms (2) entweder durch Joule-Erwärmung oder durch thermoelektrischen Effekt.

13. Verfahren zur 2D- und 3D- optisch unterstützter Füllfederhalter-Nanolithographie und Blende-Nanolithographie nach Anspruch 10 oder 11 ferner umfassend: Erreichen der vertikalen Bewegung des Öffnungsstiftkragarms (2), wobei der Öffnungsstiftkragarm (2) biomorph ist, durch eine Kombination aus piezoelektrischer Betätigung und thermischer Biegung des Öffnungsstiftkragarms (2), welche die Aufwärts- oder Abwärtsbewegung der Öffnung des Öffnungsstiftkragarms (2) in Bezug auf das Substrat (4) bewirkt.

14. Verfahren zur 2D- und 3D- optisch unterstützter Füllfederhalter-Nanolithographie und Blende-Nanolithographie nach Anspruch 1 ferner umfassend: Korrelieren der Geschwindigkeit des Öffnungsstiftkragarms (2), der Durchflußmenge der Tinte (1) und der Intensität des Lichtstrahls (5), so dass die Ablagerung der Tinte (1) unter optimalen Bedingungen erfolgt, ohne ungewollt die 2D- Muster und 3D-Strukturen, die realisiert werden, zu brechen oder zu unterbrechen.

15. Verfahren zur 2D- und 3D- optisch unterstützter Füllfederhalter-Nanolithographie und Blende-Nanolithographie nach Anspruch 1 ferner umfassend: Bereitstellen des Tintenstroms (1) entweder kontinuirlich oder intermittierend oder als durch Gasblasen getrennte Tropfen, wobei in dem kontinuierlichen Fall, dieser entweder eine konstante Flussrate oder eine zeitlich modulierte Flussrate ausweist.

16. Verfahren zur 2D- und 3D- optisch unterstützter Füllfederhalter-Nanolithographie und Blende-Nanolithographie nach Anspruch 1 ferner umfassend: Bereitstellen der Tinte (1) als photopolymerisierbares Monomer.

17. Verfahren zur 2D- und 3D- optisch unterstützter Füllfederhalter-Nanolithographie und Blende-Nanolithographie nach Anspruch 1 ferner umfassend: Bereitstellen der Tinte (1) als Monomer oder Polymer in einer Lösungsmittellösung.

18. Verfahren zur 2D- und 3D- optisch unterstützter Füllfederhalter-Nanolithographie und Blende-Nanolithographie nach Anspruch 1 ferner umfassend: Bereitstellen der Tinte (1) als Monomer oder Polymer, das mit anderen organischen Substanzen vermischt ist.

19. Verfahren zur 2D- und 3D- optisch unterstützter Füllfederhalter-Nanolithographie und Blende-Nanolithographie nach Anspruch 1 ferner umfassend: Bereitstellen der Tinte (1) als Monomer, einer Polymerlösung oder jede andere Flüssigkeit, die Nanopartikel mit spezifischen elektrischen und/oder magnetischen und/oder optischen Eigenschaften enthält.

20. Verfahren zur 2D- und 3D- optisch unterstützter Füllfederhalter-Nanolithographie und Blende-Nanolithographie nach Anspruch 1 ferner umfassend: Bilden der Tinte (1) durch eine feste Substanz, die in ihrem spezifischen Lösungsmittel gelöst ist oder durch eine flüssige organische oder anorganische Substanz, gelöst in einer anderen flüssigen Substanz, die mit ihr mischbar ist.

21. Verfahren zur 2D- und 3D- optisch unterstützter Füllfederhalter-Nanolithographie und Blende-Nanolithographie nach Anspruch 1 ferner umfassend: Variiren der Zusammensetzung der Tinte (1) während des Ablagerungverfahrens unter Verwendung eines in dem Chip (6) angeordneten mikrofluidischen Mischers, welcher in dem gewünschten Verhältnis mindestens zwei verschiedene Arten von Tinte (1) mischt.

22. Verfahren zur 2D- und 3D- optisch unterstützter Füllfederhalter-Nanolithographie und Blende-Nanolithographie nach Anspruch 1 ferner umfassend: Durchführen des Nanolithographieverfahrens in normales Luft oder in einer kontrollierten Atmosphäre hinsichtlich der Zusammensetzung und physikalischen Eigenschaften oder im Vakuum, bei einem Druck im Bereich von 10⁻¹² Torr bis 10 atm, einer Temperatur im Bereich von -200° C bis 1000°C und einer relativen Feuchtigkeit im Bereich von 0,01 % bis 99 %.

23. Verfahren zur 2D- und 3D- optisch unterstützter Füllfederhalter-Nanolithographie und Blende-Nanolithographie nach Anspruch 1 ferner umfassend: Bereitstellung der Geschwindigkeit des Öffnungsstiftkragarms in der horizontalen Ebene im Bereich von 0,001 micron/sec bis 1000 micron/sec, während die Geschwindigkeit des Öffnungsstiftkragarms in der vertikalen Richtung im Bereich von 0,001 micron/sec bis 1000 micron/sec liegt.

24. Verfahren zur 2D- und 3D- optisch unterstützter Füllfederhalter-Nanolithographie und Blende-Nanolithographie nach Anspruch 1 ferner umfassend: Bereitstellen des Lichtstrahls (5), wenn er für die Photopolymerisation der Tinte (1) verwendet wird, mit einer Wellenlänge im Bereich von 150 nm bis 650 nm Spektralbereich, wobei seine Intensität im Bereich von 1 pW/cm² - 10 MW/cm² liegt, wobei der Lichtstrahl (5) entweder kontinuierliche oder quasi-kontinuierliche Wellenart ist oder in Form von Impulse, deren Dauer im Bereich von 1 fsec bis 100 msec und eine Impulswiederholfrequenz im Bereich von 0,1 Hz bis 100 MHz aufweist, wobei die Energie pro Impuls im Bereich von 1 pJ bis 1 J liegt und einen beliebigen möglichen Kohärenzzustand aufweist.

25. Verfahren zur 2D- und 3D- optisch unterstützter Füllfederhalter-Nanolithographie und Blende-Nanolithographie nach Anspruch 1 ferner umfassend: Bereitstellen des Lichtstrahls (5), wenn dieser zum Verdampfen des in der Tintenzusammensetzung (1) enthaltenen Lösungsmittels verwendet wird, mit einer Wellenlänge im Spektralbereich von 150 nm bis 15000 nm, wobei dessen Intensität im Bereich von 1 pW/cm² bis 10 GW/cm² liegt, wobei der Lichtstrahl (5) entweder kontinuierliche oder quasi-kontinuierliche Wellenart ist oder in Form von Impulse, deren Dauer im Bereich von 1 fsec bis 100 msec und eine Impulswiederholfrequenz im Bereich von 0,1 Hz bis 100 MHz aufweist, wobei die Energie pro Impuls im Bereich von 1 pJ bis 100 J liegt und einen beliebigen möglichen Kohärenzzustand aufweist.

26. Verfahren zur 2D- und 3D- optisch unterstützter Füllfederhalter-Nanolithographie und Blende-Nanolithographie nach Anspruch 1 ferner umfassend: Bereitstellen der Flussrate der Tinte (1) in dem Bereich von 10⁻³⁰ m³/sec bis 10⁻⁹ m³/sec in dem mikrofluidischen Kanal, der direkt die Spitzenöffnung des Öffnungsstiftkragarms (2) speist.

27. Verfahren zur 2D- und 3D- optisch unterstützter Füllfederhalter-Nanolithographie und Blende-Nanolithographie nach Anspruch 1 ferner umfassend: Durchführung der Ablagerung entweder direkt oder unter Verwendung eines vorherigen Kalibrierverfahrens der Tintenablagerung (1) in 2D und in 3D, um die beste Kombination von Parametern zu gewährleisten, wie zum Beispiel Flussrate der Tinte (1), horizontale und vertikale Geschwindigkeit des Öffnungsstiftkragarms (2) und Intensität des Lichtstrahls (5).

28. Verfahren zur 2D- und 3D- optisch unterstützter Füllfederhalter-Nanolithographie und Blende-Nanolithographie nach Anspruch 27, wobei die Kalibrierung für die 2D-Lithographie ferner die folgenden Schritte umfasst:
- Bringen des Öffnungsstiftkragarms (2) in der Nähe der Oberfläche des Substrats (4), vorzugsweise durch Rückkopplung
- Die Tinte (1) erreicht die Oberfläche des Substrats (4) aufgrund einer Flüssigkeitsmeniskusbildung oder durch Anlegen eines sehr geringen Drucks auf sie von der Mikropumpe des mikrofluidischen Chips (6)
- Zeichnen von Linien auf die Oberfläche des Substrats (4) an verschiedenen Stellen, wobei jede Linie bei einem bestimmten Wert der Flussrate der Tinte (1), einer horizontalen Geschwindigkeit des Öffnungsstiftkragarms (2) und Intensität des Lichtstrahls (5) liegt
- Abbilden der gezeichneten Linien durch AFM und, aus den so gewonnenen AFM-Bildern, Messung ihrer Breite
- Anpassen der Werte der Breiten als Funktion der Flussrate der Tinte (1), der horizontalen Geschwindigkeit des Öffnungsstiftkragarms (2) und der Intensität des Lichtstrahls (5), eine mathematische Beziehung zwischen der Linienbreite und den genannten Parametern, die sich aus der genannten Anpassung ergeben
- Fernere Verwendung der erhaltenen mathematischen Beziehung, wenn eine Nanolithographie durchgeführt wird, um die geeigneten Werte für die Flussrate der Tinte (1), die horizontale Geschwindigkeit des Öffnungsstiftkragarms (2) und die Intensität des Lichtstrahls (5) festzustellen, um die gewünschte Linienbreite zu erhalten.

29. Verfahren zur 2D- und 3D- optisch unterstützter Füllfederhalter-Nanolithographie und Blende-Nanolithographie nach Anspruch 27, wobei die Kalibrierung für die 2D-Lithographie ferner die folgenden Schritte umfasst:
- Bringen des Öffnungsstiftkragarms (2) in der Nähe der Oberfläche des Substrats (4), vorzugsweise durch Rückkopplung
- Die Tinte (1) erreicht die Oberfläche des Substrats (4) aufgrund einer Flüssigkeitsmeniskusbildung oder durch Anlegen eines sehr geringen Drucks auf sie von der Mikropumpe des mikrofluidischen Chips (6)
- Halten des Öffnungsstiftkragarms (2) fest in der Position für ein bestimmtes Zeitintervall, das Verweilzeit genannt wird, so dass sich die Tinte (1) über die Oberfläche des Substrats (4) ausbreitet für bestimmte Werte der Flussrate der Tinte (1), des Verweilzeitintervalls und der Intensität des Lichtstrahls (5), wodurch ein punktartiges Muster mit einem bestimmten Durchmesser erhalten wird
- Wiederholung der zuvor erwähnten drei Schritte an einer anderen Stelle für unterschiedliche Werte von Flussrate der Tinte (1), Verweilzeit des Öffnungsstiftkragarms (2) und Intensität des Lichtstrahls (5)
- Abbilden der so erhaltenen Punktmuster durch AFM und aus den AFM-Bildern deren Durchmesser messen
- Anpassen der Werte des Durchmessers als Funktion der Flussrate der Tinte (1), der Verweilzeit des Öffnungsstiftkragarms (2) und der Intensität des Lichtstrahls (5), eine mathematische Beziehung zwischen dem Durchmesser und den genannten Parametern, die sich aus der genannten Anpassung ergeben
- Fernere Verwendung der erhaltenen mathematischen Beziehung, wenn eine Nanolithographie durchgeführt wird, um die geeigneten Werte für die Flussrate der Tinte (1), die Verweilzeit des Öffnungsstiftkragarms (2) und die Intensität des Lichtstrahls (5) festzustellen, um den gewünschten Durchmesser zu erhalten.

30. Verfahren zur 2D- und 3D- optisch unterstützter Füllfederhalter-Nanolithographie und Blende-Nanolithographie nach einer der Ansprüche von 27 bis 29, ferner umfassend: Verwendung im Kalibrierverfahren für die 2D Lithographie sowohl der Kalibrierung der Linienbreite als auch des Punktdurchmessers, um die geeigneten Größen der verschiedenen Muster zu erhalten, die auf der Oberfläche des Substrats (4) realisiert sind.

31. Verfahren zur 2D- und 3D- optisch unterstützter Füllfederhalter-Nanolithographie und Blende-Nanolithographie nach Anspruch 27, wobei der Kalibrierverfahren für die 3D-Lithographie ferner die folgenden Schritte umfasst:
- Bringen des Öffnungsstiftkragarms (2) in unmittelbaren Nähe zum Substrat (4), vorzugsweise Eintreten in das Rückkopplungsregime,
- Die Tinte (1) erreicht die Oberfläche des Substrats (4) aufgrund einer Flüssigkeitsmeniskusbildung zwischen die Spitze des Öffnungsstiftkragarms (2) und das Substrat (4) oder durch Anlegen eines sehr geringen Drucks auf sie von der Mikropumpe des mikrofluidischen Chips (6)
- Heben des Öffnungsstiftkragarms (2) entlang der vertikalen Z-Richtung mit einer vorgegebenen vertikalen Geschwindigkeit, während die Tinte (1) mit einer bestimmten Flussrate aus der Spitzenöffnung des Öffnungsstiftkragarms (2) austritt, wobei sie gleichzeitig durch den Lichtstrahl (5) mit einer bestimmten Intensität beleuchtet wird und somit eine Materialsäule mit einer bestimmten Höhe erzeugt wird
- Wiederholen der vorhergehenden Schritte an verschiedenen Stellen des Substrats (4) für verschiedene Werte der Flussrate der Tinte (1), der Geschwindigkeit des Öffnungsstiftkragarms (2) und der Intensität des Lichtstrahls (5)
- Messen der Höhen und Durchmesser der Säulen unter Verwendung der bekannten Messmittelgrößen im Mikro- und Nanometerbereich
- Anpassen der Werte des Durchmessers und beziehungsweise der Höhen als Funktion der Flussrate der Tinte (1), der Verweilzeit des Öffnungsstiftkragarms (2) und der Intensität des Lichtstrahls (5), wobei eine mathematische Beziehung, die aus dieser Anpassung resultiert, die den Säulendurchmesser beziehungsweise die Säulenhöhe mit den genannten Parametern korreliert
- Fernere Verwendung der erhaltenen mathematischen Beziehung, wenn eine 3D-Nanolithographie durchgeführt wird, um die geeigneten Werte für die Flussrate der Tinte (1), die Verweilzeit des Öffnungsstiftkragarms (2) und die Intensität des Lichtstrahls (5) festzustellen, um den gewünschten Durchmesser und die gewünschte Höhe für die Säule zu erhalten.

32. Verfahren zur 2D- und 3D- optisch unterstützter Füllfederhalter-Nanolithographie und Blende-Nanolithographie nach Anspruch 27, wobei der Kalibrierprozess für die 3D-Lithographie ferner die folgenden Schritte umfasst:
- Erzeugen einer Anzahl senkrechter, senkrecht zur Substratoberfläche (4) angeordneter vertikaler Säulen, die sich in einem bestimmtem Abstand auf dem Substrat (4) befinden,
- Bringen des Öffnungsstiftkragarms (2) oben auf einer dieser Säulen bis zu dem Moment, wenn die Tinte (1) die jeweilige Säule, durch eine flüssige Meniskusbildung oder einen sehr leichten auf sie ausgeübten Druck, erreicht und sie dann horizontal in der XY-Ebene mit einer bestimmten Horizontalgeschwindigkeit des Öffnungsstiftkragarms (2) bewegt, mit einer vorgegebenen Flussrate der Tinte (1) und vorgegebenen Intensität des Lichtstrahls (5), um eine horizontale Struktur zu schaffen, die an einem ihrer Enden durch die jeweilige Säule gehalten ist und eine vom Benutzer gewählte Länge aufweist
- Wiederholen des Vorgangs beginnend von der Oberseite einer anderen Säule und unter Verweundung einer unterschiedlichen Horizontalgeschwindigkeit des Öffnungsstiftkragarms (2), Flussrate der Tinte (1) und Intensität des Lichtstrahls (5), wodurch eine neuartige, hängende horizontale Struktur geschaffen wird
- Messen der Breiten / Durchmesser der hängenden horizontalen Strukturen unter Anwendung bekannter Techniken der Größmessung an der Mikro- und Nanoskala
- Anpassen der Werte der Breiten / Durchmesser als Funktion der Flussrate der Tinte (1), der Geschwindigkeit des Öffnungsstiftkragarms (2) und der Intensität des Lichtstrahls (5), wobei sich eine mathematische Beziehung daraus ergibt, die Säulendurchmesser / Säulenbreiten mit den genannten Parametern korreliert
- Fernere Vewendung der erhaltenen mathematischen Beziehung bei der Durchführung einer 3D-Gebäude-Nanolithographie, um die geeigneten Werte für die Flussrate der Tinte (1), die Horizontalgeschwindigkeit des Öffnungsstiftkragarms (2) und die Intensität des Lichtstrahls (5) zu erhalten, um die gewünschten Größen der horizontal aufgehängten Linien zu erhalten.

33. Verfahren zur 2D- und 3D- optisch unterstützter Füllfederhalter-Nanolithographie und Blende-Nanolithographie nach Anspruch 27, wobei der Kalibrierprozess für die 3D-Lithographie ferner die folgenden Schritte umfasst:
- Bringen des Öffnungsstiftkragarms (2) in unmittelbarer Nähe des Substrats (4), vorzugsweise Eintritt in das Rückkopplungsewgime, so dass die Tinte (1) die Oberfläche des Substrats (4) erreicht
- Heben des Öffnungsstiftkragarms (2) entlang der vertikalen Z-Richtung mit einer vorgegebenen vertikalen Geschwindigkeit, die ihn gleichzeitig auch in der horizontalen XY-Ebene mit einer anderen vorgegebenen Geschwindigkeit bewegt, wärend die Tinte (1) mit einer bestimmten Flussrate aus der Spitztenöffnung des Öffnungsstiftkragarms (2) gleichzeitig mit dem sie beleuchtenden Lichtstrahl (5) austritt, wodurch eine Materialsäule erzeugt wird, die unter einem bestimmten Winkel in Bezug auf die Oberfläche des Substrats (4) geneigt ist
- Wiederholen des Verfahrens an verschiedenen Stellen des Substrats (4) für unterschiedliche Werte der Flussrate der Tinte (1), der vertikalen und horizontalen geschwindigkeiten des Öffnungsstiftkragarms (2), beziehungsweise der Intensität des Lichtstrahls (5)
- Messen der Größe und Neigung der erzeugten geneigten Säulen unter Verwendung bekannter Techniken der Größenmessung an der Mikro- und Nanoskala
- Anpassen der Größe und, beziehungsweise, des Neigungswinkels als Funktion der Flussrate der Tinte (1), der horizontalen und vertikalen Geschwindigkeiten des Öffnungsstiftkragarms (2) und der Intensität des Lichtstrahls (5), wobei sich eine mathematische Beziehung daraus ergibt, die Säulendurchmesser, beziehungsweise Neigungswinkel der Säulen mit den genannten Parametern korreliert
- Fernere Vewendung der erhaltenen mathematischen Beziehung bei der Durchführung einer 3D-Gebäude-Nanolithographie, um die geeigneten Werte für die Flussrate der Tinte (1), die horizontale und vertikale Geschwindigkeiten des Öffnungsstiftkragarms (2) und die Intensität des Lichtstrahls (5) zu erhalten, um die gewünschten Größen und Neigungswinkel der geneigten Säulen zu erhalten.

34. Verfahren zur 2D- und 3D- optisch unterstützter Füllfederhalter-Nanolithographie und Blende-Nanolithographie nach Anspruch 27 ferner umfassend: Erreichen des Kalibrierverfahrens für 3D-Gehäuse durch eine Kombination von zwei oder mehr der 3D-Kalibrierverfahren nach den Ansprüchen 31, 32 oder 33.

35. Verfahren zur 2D- und 3D- optisch unterstützter Füllfederhalter-Nanolithographie und Blende-Nanolithographie nach einer der Ansprüche von 27 bis 34 ferner umfassend: Realisierung der 2D-Kalibrierverfahren und 3D-Kalibrierverfahren für verschiedene Werte der Anfangsviskosität der Tinte (1), wobei die Flussrate der Tinte (1) durch die Mikropumpe bestimmt wird, die in dem mikrofluidischen Chip (6) enthalten ist, welcher den unmittelbar mit der Austrittsöffnung des Öffnungsstiftkragarms (2) verbundenen mikrofluidischen Kanal mit Tinte (1) versorgt.

## Revendications

1. Méthode de nanolithographie de type stylo à encre 2D et 3D assistée optiquement et nanolithographie de stylo à ouverture, comprenant: le dépôt d'une encre (1) sur un substrat (4) en utilisant soit un stylo, soit un cantilever (2) de stylo à ouverture, se déplaçant à une vitesse appropriée horizontalement et/ou verticalement par rapport à la surface du substrat (4), le cantilever (2) ayant un canal interne relié à une puce microfluidique (6) qui fournit avec de l'encre (1) l'ouverture à sa pointe, tandis qu'un faisceau lumineux (5) est appliqué sur la zone de dépôt, le faisceau (5) ayant pour rôle soit de déclencher la photopolymérisation de l'encre (1), lorsque l'encre (1) contient une substance photopolymérisable dans sa composition, soit d'accélérer l'évaporation d'un solvant entrant dans la composition de l'encre (1), dans les deux cas, l'effet du faisceau (5) étant celui de contrôler finement la viscosité de l'encre (1) afin d'obtenir un coefficient de diffusion souhaitée de l'encre (1) sur la surface du substrat (4), respectivement d'atteindre le taux de dépôt 3D désiré de l'encre (1), le faisceau lumineux (5) étant appliqué à partir d'au moins deux directions différentes, de sorte que, quelle que soit la position et le mouvement du cantilever (2) dans l'espace, le faisceau lumineux (5) atteint l'encre (1) dans la région de dépôt du substrat.

2. Méthode de nanolithographie de type stylo à encre 2D et 3D assistée optiquement et nanolithographie de stylo à ouverture selon la revendication 1, comprenant en outre: le suivi en temps réel de la topographie de surface du substrat (4) pendant le processus de dépôt afin de compenser toute variation de hauteur du substrat (4).

3. Méthode de nanolithographie de type stylo à encre 2D et 3D assistée optiquement et nanolithographie de stylo à ouverture selon la revendication 1, comprenant en outre: la compensation de la variation de topographie de surface du substrat (4), en obtenant d'abord la topographie de surface du substrat (4) avec un balayage par microscopie à force atomique de la zone de travail et ensuite on effectue le processus de construction 2D et/ou 3D en tenant compte des données topographiques du substrat (4).

4. Méthode de nanolithographie de type stylo à encre 2D et 3D assistée optiquement et nanolithographie de stylo à ouverture selon la revendication 1, comprenant en outre: la lecture de la flexion du cantilever (2) par l'un quelconque des moyens connus en microscopie à force atomique, à savoir optiquement, piézorésistivement, capacitivement, inductivement, à condition que, dans le cas d'une lecture optique, le faisceau lumineux utilisé pour suivre le déplacement du cantilever ne favorise pas la photopolymérisation ni chauffe l'encre (1).

5. Méthode de nanolithographie de type stylo à encre 2D et 3D assistée optiquement et nanolithographie de stylo à ouverture selon la revendication 1, comprenant en outre: l'utilisation d'un seul cantilever (2) ou d'un réseau de cantilevers (2) intégrés sur la même puce, chaque cantilever (2) du réseau étant actionné indépendamment ou conjointement avec d'autres cantilevers et le dépôt du même type d'encre (1) comme les autres cantilevers ou un type d'encre différent (1).

6. Méthode de nanolithographie de type stylo à encre 2D et 3D assistée optiquement et nanolithographie de stylo à ouverture selon la revendication 1, comprenant en outre: la réalisation des motifs en 2D, soit en déplaçant le cantilever (2) horizontalement par rapport à la surface du substrat (4) avec la vitesse appropriée ou en laissant le cantilever (2) pour rester un certain temps appelé un temps de séjour dans la proximité immédiate de la surface du substrat (4), de sorte que l'encre (1) atteint la surface du substrat (4) et se propage ensuite sur elle.

7. Méthode de nanolithographie de type stylo à encre 2D et 3D assistée optiquement et nanolithographie de stylo à ouverture selon la revendication 1, comprenant en outre: la construction de la structure 3D en déplaçant le cantilever (2) le long des coordonnées spatiales X, Y, Z, en utilisant des méthodes et des systèmes de balayage (3) connus en microscopie à force atomique.

8. Méthode de nanolithographie de type stylo à encre 2D et 3D assistée optiquement et nanolithographie de stylo à ouverture selon la revendication 1, comprenant en outre: la construction de la structure 3D par un dépôt de l'encre couche par couche (1), chaque couche étant horizontale par rapport à la surface du substrat (4) et réalisé par un procédé de dépôt spécifique à la construction de motifs 2D, tandis que les couches se superposent le long de l'axe vertical Z jusqu'à obtenir la structure 3D souhaitée.

9. Méthode de nanolithographie de type stylo à encre 2D et 3D assistée optiquement et nanolithographie de stylo à ouverture selon la revendication 7 ou 8, comprenant en outre: la construction de la structure 3D par une combinaison de déplacement du cantilever (2) le long des coordonnées spatiales X, Y, Z en utilisant des procédés et des systèmes de balayage (3) connus en microscopie à force atomique et un dépôt de l'encre (1) couche par couche.

10. Méthode de nanolithographie de type stylo à encre 2D et 3D assistée optiquement et nanolithographie de stylo à ouverture selon la revendication 1 comprenant en outre: la réalisation d'un mouvement vertical du cantilever (2) au moyen d'un système d'actionnement piézoélectrique connu inclus dans le système de balayage (3) et spécifique à tout type de microscopes à force atomique.

11. Méthode de nanolithographie de type stylo à encre 2D et 3D assistée optiquement et nanolithographie de stylo à ouverture selon la revendication 1 comprenant en outre: la réalisation d'un mouvement vertical du cantilever (2) dans lequel le cantilever (2) est bimorphe, par variation de la température du cantolever (2) par tous moyens et procédés de chauffage connus.

12. Méthode de nanolithographie de type stylo à encre 2D et 3D assistée optiquement et nanolithographie de stylo à ouverture selon la revendication 11 comprenant en outre: l'obtention de la variation de température en cantilever (2) soit par chauffage Joule, soit par l'effet thermoélectrique.

13. Méthode de nanolithographie de type stylo à encre 2D et 3D assistée optiquement et nanolithographie de stylo à ouverture selon la revendication 10 ou 11 comprenant en outre: la réalisation du mouvement vertical du cantilever (2), dans lequel le cantilever (2) est bimorphe, par une combinaison d'actionnement piézoélectrique et de flexion thermique du cantilever (2) donnant lieu au mouvement de montée ou de descente de l'ouverture de la pointe du cantilever (2) par rapport au substrat (4).

14. Méthode de nanolithographie de type stylo à encre 2D et 3D assistée optiquement et nanolithographie de stylo à ouverture selon la revendication 1, comprenant en outre: la corrélation de la vitesse du cantilever (2), le débit de l'encre (1) et l'intensité du faisceau lumineux (5) de sorte que le dépôt de l'encre (1) est réalisé dans des conditions optimales sans briser ou interrompre involontairement les motifs 2D et les structures 3D réalisées.

15. Méthode de nanolithographie de type stylo à encre 2D et 3D assistée optiquement et nanolithographie de stylo à ouverture selon la revendication 1, comprenant en outre: la livraison d'écoulement de l'encre (1) soit en continu, soit en intermittence ou en gouttes séparées par des bulles de gaz, dans le cas continu ayant soit un débit constant, soit un débit modulé dans le temps.

16. Méthode de nanolithographie de type stylo à encre 2D et 3D assistée optiquement et nanolithographie de stylo à ouverture selon la revendication 1, comprenant en outre: la livraison de l'encre (1) en tant que monomère photopolymérisable.

17. Méthode de nanolithographie de type stylo à encre 2D et 3D assistée optiquement et nanolithographie de stylo à ouverture selon la revendication 1, comprenant en outre: la livraison de l'encre (1) en tant que monomère ou polymère dans une solution de solvant.

18. Méthode de nanolithographie de type stylo à encre 2D et 3D assistée optiquement et nanolithographie de stylo à ouverture selon la revendication 1, comprenant en outre: la livraison de l'encre (1) en tant que monomère ou polymère mélangé à d'autres substances organiques.

19. Méthode de nanolithographie de type stylo à encre 2D et 3D assistée optiquement et nanolithographie de stylo à ouverture selon la revendication 1, comprenant en outre: la livraison de l'encre (1) en tant que monomère, une solution de polymère ou de tout autre liquide qui contient des nanoparticules ayant des propriétés électriques et/ou magnétiques et/ou optiques spécifiques.

20. Méthode de nanolithographie de type stylo à encre 2D et 3D assistée optiquement et nanolithographie de stylo à ouverture selon la revendication 1, comprenant en outre: la préparation de l'encre (1) par une substance solide dissoute dans son solvant spécifique, ou par une substance organique ou inorganique liquide dissoute dans une autre substance liquide miscible avec elle.

21. Méthode de nanolithographie de type stylo à encre 2D et 3D assistée optiquement et nanolithographie de stylo à ouverture selon la revendication 1, comprenant en outre: on fait varier la composition de l'encre (1) au cours du procédé de dépôt par l'utilisation d'un mélangeur microfluidique placé à l'intérieur de la puce (6), ledit mélangeur mélange au moins deux types différents d'encre (1) dans la proportion souhaitée.

22. Méthode de nanolithographie de type stylo à encre 2D et 3D assistée optiquement et nanolithographie de stylo à ouverture selon la revendication 1 comprenant en outre: la réalisation du procédé de nanolithographie dans l'air normal ou dans une atmosphère contrôlée en ce qui concerne la composition et les propriétés physiques, ou sous vide, à une pression comprise dans l'intervalle de 10⁻¹² Torr - 10 atm, dans la plage de températures de -200°C - 1000°C et une humidité relative comprise dans l'intervalle 0,01% - 99%.

23. Méthode de nanolithographie de type stylo à encre 2D et 3D assistée optiquement et nanolithographie de stylo à ouverture selon la revendication 1 comprenant en outre: l'assurance de la vitesse du cantilever dans le plan horizontal dans l'intervalle de 0,001 microns/s - 1000 microns/sec tandis que la vitesse de cantilever dans la direction verticale est dans l'intervalle 0.001 microns/s - 1000 microns/s.

24. Méthode de nanolithographie de type stylo à encre 2D et 3D assistée optiquement et nanolithographie de stylo à ouverture selon la revendication 1 comprenant en outre: la livraison du faisceau (5), lorsqu'il est utilisé pour la photopolymérisation de l'encre (1), avec une longueur d'onde dans la plage spectral à 150 nm- 650 nm, son intensité se situant dans la plage 1 pW/cm² - 10 MW/cm², le faisceau (5) étant soit du type à onde continue, soit quasi-continue, soit en impulsions, des impulsions dont la durée se situe dans la plage 1 fsec - 100 msec et ont une fréquence de répétition des impulsions dans la plage 0,1 Hz - 100 MHz, l'énergie par impulsion étant dans la plage 1 pJ-1 J et ayant l'un quelconque état de cohérence possible.

25. Méthode de nanolithographie de type stylo à encre 2D et 3D assistée optiquement et nanolithographie de stylo à ouverture selon la revendication 1 comprenant en outre: la livraison du faisceau (5), lorsqu'il est utilisé pour évaporer le solvant contenu dans la composition de l'encre (1), avec une longueur d'onde contenue dans l'intervalle de 150 nm - 15000 nm intervalle spectral, son intensité étant dans l'intervalle 1 pW/cm² - 10 GW/cm², le faisceau (5) étant soit du type à onde continue, soit quasi-continue, soit en impulsions, des impulsions dont la durée se situe dans la plage 1 fsec - 100 msec et ont une fréquence de répétition d'impulsions dans la plage 0,1 Hz - 100 MHz, l'énergie par impulsion étant dans la plage 1 pJ-100J et ayant l'un quelconque état de cohérence possible.

26. Méthode de nanolithographie de type stylo à encre 2D et 3D assistée optiquement et nanolithographie de stylo à ouverture selon la revendication 1 comprenant en outre: la livraison du débit de l'encre (1) dans la plage de 10⁻³⁰m³/ s - 10⁻⁹m³/s, dans le canal microfluidique qui fournit directement l'ouverture de la pointe de cantilever (2).

27. Méthode de nanolithographie de type stylo à encre 2D et 3D assistée optiquement et nanolithographie de stylo à ouverture selon la revendication 1 comprenant en outre: la réalisation du dépôt soit directement, soit en utilisant un procédé de calibrage précédent du dépôt de l'encre (1) en 2D et en 3D, ledit processus de calibrage visant à assurer la meilleure combinaison de paramètres, tels que le débit d'encre (1), le cantilever (2), les vitesses horizontales et verticales du cantilever (2) et l'intensité du faisceau (5).

28. Méthode de nanolithographie de type stylo à encre 2D et 3D assistée optiquement et nanolithographie de stylo à ouverture selon la revendication 27 dans lequel le calibrage pour la lithographie 2D comprend en outre les étapes suivantes:
- on amene le cantilever (2) à proximité immédiate de la surface du substrat (4), entrant de préférence dans le mode feedback
- l'encre (1) atteind la surface du substrat (4) due à la formation du ménisque liquide ou en appliquant une très légère pression sur celle-ci par la micropompe de la puce microfluidique (6)
- on trace des lignes sur la surface du substrat (4) en différents endroits, chaque ligne à une valeur spécifique du débit d'encre (1), de la vitesse horizontale du cantilever (2) et de l'intensité du faisceau (5)
- on fait l'imagerie des lignes tracées par AFM et on mesure leur largeur, à partir des images AFM ainsi acquises,
- on ajuste les valeurs des largeurs en fonction du débit d'encre (1), de la vitesse horizontale du cantilever *(2)* et de l'intensité du faisceau (5), une relation mathématique entre la largeur de ligne et lesdits paramètres résultant dudit ajustement
- on utilise en outre la rélation mathématique obtenue lors de la réalisation de la nanolithographie afin d'établir les valeurs appropriées pour le débit de l'encre (1), pour la vitesse horizontale du cantilever (2) et pour l'intensité du faisceau (5) de manière à obtenir la largeur de ligne souhaitée.

29. Méthode de nanolithographie de type stylo à encre 2D et 3D assistée optiquement et nanolithographie de stylo à ouverture selon la revendication 27, dans lequel le calibrage pour la lithographie 2D comprend en outre les étapes suivantes:
- on amene le cantilever *(2)* à proximité immédiate de la surface du substrat (4) entrant de préférence dans le mode de feedback
- l'encre (1) atteind la surface du substrat (4) due à la formation d'un ménisque liquide, ou en appliquant une très légère pression sur celle-ci par la micropompe de la puce microfluidique (6)
- on maintient le cantilever *(2)* fixé dans la position pendant un certain intervalle de temps appelé temps de séjour, de manière que l'encre (1) se propage sur la surface du substrat (4) pour des valeurs spécifiées du débit d'encre (1), de l'intervalle de temps de séjour et de l'intensité du faisceau (5), obtenant ainsi un motif en forme de point ayant un certain diamètre
- on répéte les trois étapes mentionnées précédemment dans un autre endroit pour différentes valeurs du débit d'encre (1), l'intervalle de temps de séjour du cantilever (2) et de l'intensité de faisceau (5)
- on fait l'imagerie des motifs des points ainsi obtenus par AFM et on mesure leurs diamètres à partir des images AFM,
- on ajuste les valeurs des diamètres en fonction du débit d'encre (1), du temps de séjour du cantilever (2) et de l'intensité de faisceau (5), une relation mathématique entre le diamètre et lesdits paramètres résultant dudit ajustement
- on utilise en outre la relation mathématique obtenue lors de la réalisation de la nanolithographie afin d'établir les valeurs appropriées pour le débit d'encre (1), le temps de séjour du cantilever (2) et l'intensité de faisceau (5), de manière à obtenir le diamètre désiré du motif.

30. Méthode de nanolithographie de type stylo à encre 2D et 3D assistée optiquement et nanolithographie de stylo à ouverture selon l'une quelconque de revendications 27-29, comprenent en outre: l'utilisation, dans le processus de calibrage pour la lithographie 2D, du calibrage de la largeur de ligne et du diamètre des points, afin d'obtenir les tailles appropriées des différents motifs réalisés sur la surface du substrat (4).

31. Méthode de nanolithographie de type stylo à encre 2D et 3D assistée optiquement et nanolithographie de stylo à ouverture selon la revendication 27, dans lequel le processus de calibrage pour la lithographie 3D comprend en outre les étapes suivantes:
- on amène le cantilever (2) à proximité immédiate du substrat (4), entrant de préférence dans le mode de feedback
- l'encre (1) atteint la surface du substrat (4) due soit à un ménisque liquide formé entre la pointe du cantilever (2) et le substrat (4), soit à une très faible pression appliquée à l'encre (1) par la micropompe contenue par la puce microfluidique (6)
- on lève le cantilever (2) le long de la direction verticale Z avec une vitesse verticale spécifiée tandis que l'encre (1), ayant un débit spécifié, sort de l'ouverture de pointe du cantilever (2) étant éclairé simultanément par le faisceau (5) qui a une intensité spécifiée et, ainsi, on crée une colonne de matériau ayant une certaine hauteur
- on répéte les étapes précédentes, à différents endroits du substrat (4), pour différentes valeurs du débit d'encre (1), de la vitesse verticale du cantilever (2) et de l'intensité du faisceau (5)
- on mesure les hauteurs et les diamètres des colonnes en utilisant les moyens connus de mesure de la taille aux niveaux micro- et nanométrique
- on ajuste les valeurs des diamètres et respectivement des hauteurs en tant que fonction du débit d'encre (1), de la vitesse verticale du cantilever (2) et de l'intensité du faisceau (5), une relation mathématique résultant de cet ajustement qui corrèle le diamètre de la colonne, respectivement l'hauteur de la colonne pour lesdits paramètres
- on utilise en outre la relation mathématique obtenue lors de la réalisation de la nanolithographie 3D afin d'etablir les valeurs appropriée pour le débit d'encre (1), la vitesse verticale du cantilever (2) et l'intensité du faisceau (5), de manière à obtenir le diamètre et l'hauteur désirés de la colonne.

32. Méthode de nanolithographie de type stylo à encre 2D et 3D assistée optiquement et nanolithographie de stylo à ouverture selon la revendication 27, où le processus de calibrage pour la lithographie 3D comprend en outre les étapes suivantes:-
- on crée un certain nombre de colonnes verticales perpendiculaires à la surface du substrat (4), placées à la distance spécifiée sur le substrat (4)
- on amène le cantilever (2) à la partie supérieure de l'une de ces colonnes jusqu'au moment où l'encre (1), en raison de la formation d'un ménisque liquide, ou à une très légère pression qui lui est appliquée, atteint la colonne respective et puis en la déplaçant horizontalement dans le plan XY avec une vitesse horizontale spécifiée du cantilever (2), avec un débit spécifié d'encre (1) et une intensité spécifiée du faisceau (5) afin de créer une structure horizontale supportée à l'une de ses extrémités par la colonne respective et ayant une longueur choisie par l'utilisateur
- on répète le processus à partir de la partie supérieure d'une autre colonne en utilisant la vitesse horizontale du cantilever (2), le débit d'encre (1) et l'intensite du faisceau (5) différentes, ainsi étant créé une nouvelle structure suspendue horizontalement
- on mesure les largeurs/diamètres des structures suspendues horizontalement en utilisant des techniques connues pour mesurer la dimension à micro- et nano échelle
- on ajuste les valeurs des largeurs/diamètres en fonction de débit de l'encre (1), de la vitesse horizontale du cantilever (2) et de l'intensité du faisceau (5), une relation mathématique résultant de cet ajustement qui corrèle le diamètre/largeurs de la colonne pour lesdits paramètres
- on utilise de plus la relation mathématique obtenu pendant l'exécution de la nanolithographie 3D afin d'établir des valeurs appropriées pour le débit d'encre (1), la vitesse horizontale du cantilever (2) et l'intensité du faisceau (5) de manière à obtenir les dimensions souhaitées des lignes suspendues horizontalement.

33. Méthode de nanolithographie de type stylo à encre 2D et 3D assistée optiquement et nanolithographie de stylo à ouverture selon la revendication 27, dans lequel le procédé de calibrage pour la lithogreaphie 3D comprend en outre les étapes suivantes:
- on amène le cantilever (2) à proximité immédiate du substrat (4), de préférence entrant dans le mode de feedback, de sorte que l'encre (1) atteint la surface du substrat (4)
- on lève le cantilever (2) le long de la direction verticale Z avec une vitesse verticale spécifiée en le déplaçant simultanément dans le plan horizontal XY avec une autre vitesse spécifiée tandis que l'encre (1) ayant un débit spécifié, sort de l'ouverture de la pointe du cantilever (2) en même temps que le faisceau (5) qui l'éclaire et donc on crée une colonne de matériau inclinée au certain angle par rapport à la surface du substrat (4)
- on répète le processus à différents endroits du substrat(4), pour différentes valeurs pour le débit d'encre (1), les vitesses verticales et horizontales du cantilever (2), respectivement l'intensité du faisceau (5)
- on mesure la taille et l'inclinaison des colonnes inclinées réalisées en utilisant des techniques connues de mesure aux niveaux micro- et nanométrique
- on ajuste la taille et, respectivement, l'angle d'inclinaison en fonction de débit de l'encre (1), des vitesses horizontales et verticales du cantilever (2) et d'intensité du faisceau (5), ainsi la relation mathématique résultant de cette ajustement corrèle le diametre de la colonne, respectivement l'angle d'inclinaison de la colonne auxdits paramètres
- on utilise la relation mathématique obtenue lors de la réalisation de la nanolithographie 3D afin d'établir les valeurs appropriées pour le débit d'encre (1), les vitesses horizontales et verticales du cantilever (2) et l'intensité du faisceau (5), de manière à obtenir les dimensions et les angles d'inclinaison souhaités pour les colonnes inclinées.

34. Méthode de nanolithographie de type stylo à encre 2D et 3D assistée optiquement et nanolithographie de stylo à ouverture selon la revendication 27, comprenant en outre: la réalisation de la méthode de calibrage pour le cas 3D par une combinaison de deux ou plus des deux méthodes de calibrage 3D selon les revendications 31, 32 ou 33.

35. Méthode de nanolithographie de type stylo à encre 2D et 3D assistée optiquement et nanolithographie de stylo à ouverture selon l'une quelconque des revendications 27 - 34 comprenant en outre: la réalisation des méthodes de calibrage 2D et 3D pour différentes valeurs de la viscosité initiale de l'encre (1), ayant un débit d'encre (1) déterminé par la micropompe contenue dans la puce microfluidique (6) qui fournit l'encre (1) au canal microfluidique directement lié à l'ouverture de sortie de l'extrémité du cantilever (2).
